**Europäisches Patentamt**

**European Patent Office**

**Office européen des brevets**

(19)

(11) Publication number : **0 414 363 B1**

(12) # EUROPEAN PATENT SPECIFICATION

(45) Date of publication of patent specification :
**11.10.95 Bulletin 95/41**

(51) Int. Cl.⁶ : **H05K 3/10**

(21) Application number : **90307548.9**

(22) Date of filing : **10.07.90**

(54) Method for applying a conductive trace pattern to a substance.

(30) Priority : **21.08.89 US 397145**

(43) Date of publication of application :
**27.02.91 Bulletin 91/09**

(45) Publication of the grant of the patent :
**11.10.95 Bulletin 95/41**

(84) Designated Contracting States :
**DE FR GB IT**

(56) References cited :
DE-A- 2 556 756
GB-A- 2 215 139
US-A- 4 668 533
PATENT ABSTRACTS OF JAPAN vol. 13, no.
142 (E-739)(3490) 7 April 1989; &
JP-A-63304692

(73) Proprietor : **Hewlett-Packard Company**
**Mail Stop 20 B-O,**
**3000 Hanover Street**
**Palo Alto, California 94304 (US)**

(72) Inventor : **Cloutier, Frank L.**
**37 Stevens Road No. 04-01**
**Singapore 1025 (SG)**
Inventor : **Min, Siow Wee**
**Blk 407, Bedok North Avenue 3,**
**No. 05-185**
**Singapore 1646 (SG)**
Inventor : **Chieng, Ching King**
**Block 117, No. 07-3755 Bukit Merah Central**
**Singapore 0315 (SG)**

(74) Representative : **Colgan, Stephen James et al**
**CARPMAELS & RANSFORD**
**43 Bloomsbury Square**
**London WC1A 2RA (GB)**

## Description

### Background of the Invention

The present invention generally relates to the formation of electrical traces on a substrate, and more particularly to the formation of electrical traces using an ink jet system to apply a circuit pattern, followed by the application of a powdered metal composition which is melted to produce the traces.

The development of increasingly sophisticated computer and electronic systems has created a corresponding need for circuit production methods of improved efficiency and economy. In order to achieve these goals, many circuit fabrication methods have been developed and used. For example, U.S. Patent No. 4,668,533 to Miller involves a printed circuit production method which uses an ink containing a conductive metal or metal-containing activator. In a preferred embodiment, the ink is delivered using an ink jet system, followed by the application of a secondary metal layer using an electroless metal plating solution. Other methods of circuit fabrication involve the use of screen printing techniques which are well known in the art.

Another example for applying a conductive trace pattern to a substrate is disclosed in Patent Abstracts of Japan, vol. 13, no. 142 (E-739)(3490), 7 April 1989 & JP-A-63 304 692 (NEC Corp.), 12 December 1988.).

However, a need remains for an improved method of manufacturing conductive circuit traces in a rapid and efficient manner with a minimal number of process steps. The present invention satisfies this need, as described herein below.

### Summary of the Invention

It is an object of the present invention to provide a circuit fabrication method which is capable of producing conductive traces on a substrate in an efficient and rapid manner.

It is another object of the invention to provide a circuit fabrication method which uses a minimal number of process steps.

It is another object of the invention to provide a circuit fabrication method which is readily adaptable to large-scale, mass production manufacturing conditions.

It is a further object of the invention to provide a circuit fabrication method which is usable with a wide variety of substrates.

It is a still further object of the invention to provide a circuit fabrication method which uses readily available, economical materials.

It is an even further object of the invention to provide a circuit fabrication method which uses ink jet technology to deliver an ink pattern to a substrate, followed by the application of a powdered metal composition thereto which is subsequently melted.

In accordance with the foregoing objects, a fabrication method for efficiently applying electrically conductive circuit traces to a substrate is disclosed as specified in claim 1 hereinafter. The method uses an ink composition which is applied to a selected substrate by an ink jet delivery system. The ink contains about 5 - 40 % by weight adhesive preferably in combination with other additives, including one or more solvents. The ratios and proportions of these ingredients may be experimentally varied, depending on the substrate to which the ink is applied, and other extrinsic factors. Preferred substrates comprise thermoplastic materials including but not limited to ABS (acrylonitrile-butadiene-styrene), PVC (polyvinyl chloride), and PC (polycarbonate) as well as polyester film. The ink is delivered by the ink jet system in a selected pattern, followed by the application of a powdered metal composition to the pattern which adheres to the adhesive in the ink. After the removal of excess powdered metal, the substrate is heated at a temperature of about 100 - 250 degrees centigrade in order to melt the powder on the substrate. This procedure produces a pattern of conductive traces substantially identical to the ink pattern initially applied to the substrate.

These and other objects, features, and advantages of the invention will become apparent from the following Detailed Description of a Preferred Embodiment and Drawings.

### Brief Description of the Drawings

Fig. 1 is a schematic representation of the process steps, materials, and components used to produce conductive traces on a substrate in accordance with the invention.

Fig. 2 is an enlarged schematic representation showing the formation of a conductive trace pattern on a substrate using an adhesive-based ink and powdered metal composition.

Detailed Description of a Preferred Embodiment

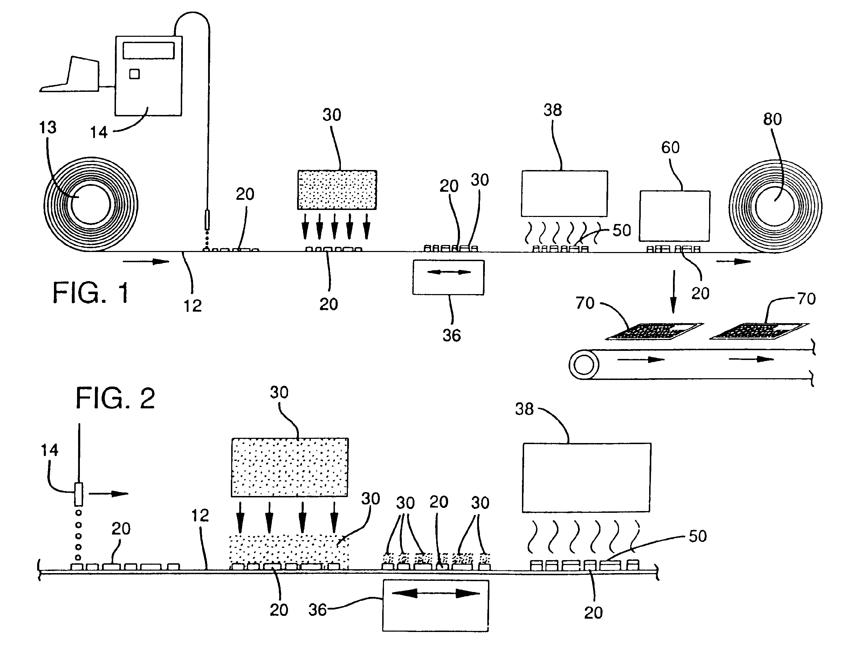

The present invention involves an improved method for producing conductive circuit traces in a highly efficient and economical manner. In accordance with the invention, an ink composition is first used to form a selected circuit pattern on a substrate. With reference to Fig. 1, a substrate 12 is illustrated. A wide variety of substrates known in the art may be used, including thin-film polyester, ABS (acrylonitrile-butadiene-styrene) plastic, PC (polycarbonate) plastic, PVC (polyvinyl chloride) plastic, and PC/ABS (50:50) blends. Other substrates may be used, and the invention shall not be limited to those listed above.

To implement the present invention on a mass-production scale, it is desirable to dispense the substrate 12 from a roll 13 (Fig. 1.), although the substrate 12 may be in the form of a single flat sheet if desired. As the substrate 12 is delivered from the roll 13, it moves toward and through a computer controllable ink jet printing apparatus 14 known in the art. In a preferred embodiment, a thermal ink jet printing system is used. Typical thermal ink jet systems include an ink reservoir in fluid communication with an orifice plate and resistor assembly. These types of systems are known in the art, and described in the Hewlett-Packard Journal, May 1985, Vol. 36, No. 5. In addition, exemplary ink jet systems with which the invention may be used are illustrated in U.S. Patents 4,500,895; 4,794,409; 4,791,438; 4,677,447; and 4,490,728. However, the invention shall not be limited to any particular type of ink jet system, and may be implemented using a wide variety of systems known in the art, including those listed above.

The ink jet printing apparatus 14 is designed to dispense ink in a selected circuit pattern 20 on the substrate 12 (Figs. 1 and 2.) The geometry of the circuit pattern 20 may be varied as desired, depending on the ultimate use for which the circuit is intended. In a preferred embodiment, the pattern 20 will have a thickness of about 0.5 - 2.0 mil (1.0 mil = 2,540 · $10^{-5}$ m), whereby 1,0 mil is preferred.

The printing apparatus 14 is supplied with a specially formulated ink composition designed to adhere to the substrate 12 in a rapid and secure manner. In accordance with the invention, the composition includes about 5 - 40% by weight adhesive (30% by weight = preferred), and about 60 - 95% by weight solvent (70% by weight = preferred.) A preferred adhesive usable in the invention is a product manufactured by the Loctite Corporation of Cleveland, Ohio under the name "Loctite 408." This material consists of a cyanoacrylate-based compound. Another adhesive which may be used is manufactured by Emhart Australia Pty. Ltd. of Victoria, Australia under the name "Bostik Super Bond." However, the present invention shall not be limited to the specific adhesives described above, and other adhesives known in the art may be used accordingly. These adhesives should be non-toxic, non-flammable, have a viscosity of about 5 - 100 cps, and a surface tension of about 20 - 60 dynes/cm.

As previously indicated, the adhesive is combined with one or more solvents. Exemplary solvents include ethylene glycol phenyl ether, gamma-butyrolactone, methyl ethyl ketone, water, and mixtures thereof. Other solvents known in the art may be used, and the invention shall not be limited to the solvents listed above. In addition, the solvents may be mixed in a variety of experimentally determined combinations, depending on the substrate/adhesive involved, as well as type of ink jet delivery system being used.

A variety of specific ink compositions produced in accordance with the invention are described below in the following Examples:

EXAMPLE 1

| COMPONENT | WT % |
|---|---|
| Loctite 408 (adhesive) | 30 |
| gamma butyrolactone (solvent) | 50 |
| methyl ethyl ketone (solvent) | 10 |
| ethylene glycol phenyl ether (solvent) | 5 |
| water (solvent) | 5 |
| | 100% |

EXAMPLE 2

| COMPONENT | WT % |
|---|---|
| Bostik Super Bond (adhesive) | 30 |
| gamma butyrolactone (solvent) | 50 |
| methyl ethyl ketone (solvent) | 10 |
| ethylene glycol phenyl ether (solvent) | 5 |
| water (solvent) | 5 |
| | 100% |

EXAMPLE 3

| COMPONENT | WT % |
|---|---|
| Loctite 408 (adhesive) | 40 |
| gamma butyrolactone (solvent) | 50 |
| methyl ethyl ketone (solvent) | 5 |
| water (solvent) | 5 |
| | 100% |

In a preferred embodiment, the ink composition will have a viscosity of about 5 - 25 cps (10 cps = optimum), and a surface tension of about 30 - 60 dynes/cm (50 dynes/cm = optimum, 1 dyne = $10^{-5}$ N).

After application of the pattern 20 to the substrate 12, a powdered metal composition 30 having a preferred average particle size diameter of 30 - 50 microns (40 microns = optimum) is applied to the pattern 20 (Figs. 1 and 2). In a preferred embodiment, the powdered metal composition 30 consists of a lead/tin alloy (about 37% by weight lead and about 63% by weight tin) in the form of spherical units. This material is commercially available from the Litton-Kester Co. of Chicago, Ill.

Other powdered metal compositions which may be used herein include the following, all of which are available from the Litton-Kester Co.:

COMPOSITION 1

| METAL | WEIGHT % |
|---|---|
| Tin | 60 |
| Lead | 40 |
| | 100% |

4

COMPOSITION 2

| METAL | WEIGHT % |
|-------|----------|
| Tin | 62 |
| Lead | 36 |
| Silver | 2 |
| | 100% |

COMPOSITION 3

| METAL | WEIGHT % |
|-------|----------|
| Tin | 42 |
| Bismuth | 58 |
| | 100% |

COMPOSITION 4

| METAL | WEIGHT % |
|-------|----------|
| Tin | 43 |
| Lead | 43 |
| Bismuth | 14 |
| | 100% |

COMPOSITION 5

| METAL | WEIGHT % |
|-------|----------|
| Tin | 37.5 |
| Lead | 37.5 |
| Indium | 25 |
| | 100% |

However, the present invention shall not be limited to only those compositions listed above, which may contain other metals including antimony.

After application of the powdered metal composition 30, which is applied in an amount slightly greater than that.necessary to cover the pattern 20, the excess composition 30 is removed from the pattern 20 and substrate 12. This is preferably accomplished through the use of a vibrating apparatus 36 known in the art. A vibrating apparatus 36 suitable for use in the present invention consists of a vibrating platform manufactured by the M-Rad Corporation of Woburn, Mass. In a preferred embodiment, the platform is adjusted to vibrate

5

the substrate 12 at a frequency of about 60 Hz. Other methods may also be used to remove excess composition 30 from the substrate 12, including the use of an air blower system (not shown) designed to generate air streams which displace excess composition 30 from the substrate 12.

Next, the remaining powdered metal composition 30 on the pattern 20 is melted using a heater 38. The heater 38 may consist of a conventional infra-red heating unit, convection oven or similar apparatus known in the art. The amount of heat supplied by the heater 38 must be sufficient to melt the composition 30 on the pattern 20 in a short period of time (e.g. 0.5 - 10 minutes.) In a preferred embodiment, the substrate 12, pattern 20, and composition 30 are heated at a temperature of about 100 - 250 degrees C over a time period of about 0.5 - 10 minutes. If the composition 30 consists of the material described above which is manufactured from a 37% lead/63% tin alloy, a preferred temperature of about 200 degrees C is applied for a time period of about 2 minutes.

The application of heat as described above effectively melts the composition 30 onto the pattern 20 and substrate 12, thereby producing a conductive trace pattern 50 (Fig. 2) substantially identical to the previously-applied pattern 20.

The substrate 12 with the completed trace pattern 50 thereon is then cut as desired using a cutter 60 known in the art to produce individual circuit units 70 suitable for use in a wide variety of applications. In addition, any residual substrate 12 is preferably fed onto a collection roll 80, as illustrated in Fig. 1.

The present invention represents a highly efficient method of applying metal trace patterns to a substrate. It is especially suitable for use in high-speed, mass production manufacturing facilities. In addition, the use of an ink jet system to apply an initial pattern to the substrate enables the pattern to be applied in a highly precise and controlled manner.

Accordingly, it is anticipated that suitable modifications may be made to the invention by individuals skilled in the art which are entirely within the scope of the invention. For example, the chemicals used to prepare the ink, as well the materials used in the powdered metal composition may be selectively varied. Thus, the present invention shall only be construed in accordance with the following claims:

## Claims

1. A method for applying conductive traces (50) to a substrate (12) comprising:
    providing a substrate (12);
    providing a supply of ink comprising about 5 to 40% by weight of at least one adhesive therein;
    supplying said ink to a thermal ink jet printing apparatus (14); and
    activating said apparatus (14) in order to deliver said ink to said substrate (12) in a pattern (12);
    providing a metal powder (30) which melts at a temperature of about 100-250 degrees centigrade;
    applying said metal powder (30) onto said pattern (20) in an amount sufficient to cover said pattern (20), said metal powder (30) adhering to said adhesive in said ink;
    removing any excess amounts of said metal powder (30) from said pattern (20); and
    heating said substrate (12) at a temperature of about 100 to 250 degrees centigrade so as to melt said metal powder (30) on to said pattern (20) in order to form an arrangement of conductive traces (50) thereon identical with said pattern (20).

2. The method of claim 1 wherein said substrate (12) comprises a material selected from polyester, acrylonitrile-butadiene-styrene plastic, polyvinyl chloride plastic, polycarbonate plastic, and mixtures thereof.

3. The method of any preceding claim wherein said metal powder (30) comprises a metal selected from lead, tin, silver, indium, bismuth, antimony and mixtures thereof.

4. The method of any preceding claim wherein said metal powder (30) comprises a plurality of individual particles each having an average diameter of about 30 - 150 microns.

5. The method of claim 7 wherein said substrate (12) with said pattern (20) and metal powder (30) thereon is heated at said temperature for about 0.5 - 10 minutes.

6. The method of any preceding claim wherein said removing of said excess amounts of said metal powder (30) comprises agitating said substrate (12) with said pattern and metal powder (30) thereon in an amount sufficient to displace said excess amounts of said metal powder (30) from said substrate (12).

EP 0 414 363 B1

**Patentansprüche**

1. Ein Verfahren zum Aufbringen von leitfähigen Spuren (50) auf einem Substrat (12), mit folgenden Schritten:

Bereitstellen eines Substrats (12);

Bereitstellen eines Tintenvorrats, der etwa 4 bis 40 Gewichtsprozent von zumindest einem Haftmittel darin umfaßt;

Zuführen der Tinte zu einer thermischen Tintenstrahldruckanordnung (14);

Aktivieren der Anordnung (14), um die Tinte auf das Substrat (12) in einer Struktur (20) aufzubringen;

Bereitstellen eines Metallpulvers (30), das bei einer Temperatur von etwa 100 bis 250 Grad Celsius schmilzt;

Aufbringen des Metallpulvers (30) auf die Struktur (20) mit einer Menge, die ausreichend ist, um die Struktur (20) zu bedecken, wobei das Metallpulver (30) an dem Haftmittel in der Tinte anhaftet;

Entfernen jeglichen Überschußmengen des Metallpulvers (30) von der Struktur (20); und

Erhitzen des Substrats (12) bei einer Temperatur von etwa 100 bis 250 Grad Celsius, um das Metallpulver (30) auf der Struktur (20) zu schmelzen, um eine Anordnung von leitfähigen Spuren (50) darauf zu bilden, die mit der Struktur (20) identisch sind.

2. Das Verfahren nach Anspruch 1, bei dem das Substrat (12) ein Material umfaßt, das aus Polyester, Acrylnitril-Butadien-Styrol-Kunststoff, Polyvinylchlorid-^unststoff, Polykarbonat-Kunststoff und Mischungen daraus ausgewählt ist.

3. Das Verfahren nach irgendeinem vorhergehenden Anspruch, bei dem das Metallpulver (30) ein Metall umfaßt, das aus Blei, Zinn, Silber, Indium, Wismut, Antimon und Mischungen daraus ausgewählt ist.

4. Das Verfahren nach irgendeinem vorhergehenden Anspruch, bei dem das Metallpulver (30) eine Mehrzahl von einzelnen Partikeln umfaßt, die jeweils einen mittleren Durchmesser von etwa 30 bis 150 Mikrometer haben.

5. Das Verfahren nach Anspruch 7, bei dem das Substrat (12) mit der Struktur (20) und dem Metallpulver (30) darauf bei der Temperatur für etwa 0,5 bis 10 Minuten erhitzt wird.

6. Das Verfahren nach irgendeinem der vorhergehenden Ansprüche, bei dem das Entfernen der Überschußmengen des Metallpulvers (30) das Bewegen des Substrats (12) mit der Struktur und dem Metallpulver (30) darauf um einen Betrag einschließt, der ausreichend ist, um die Überschußmengen des Metallpulvers (30) von dem Substrat (12) zu entfernen.

**Revendications**

1. Procédé pour appliquer des traces conductrices (50) sur un substrat (12), comprenant :
   - la fourniture d'un substrat (12);
   - la fourniture d'une alimentation d'encre comprenant environ 5 à 40 % en poids d'au moins un adhésif;
   - l'alimentation avec ladite encre d'un appareil d'impression à jet d'encre thermique (14); et
   - l'activation dudit appareil (14) afin de fournir ladite encre audit substrat (12) dans un motif (12);
   - la réalisation d'une poudre métallique (30) qui fond à une température d'environ 100-250 degrés centigrade;
   - l'application de ladite poudre métallique (30) sur ledit motif (20) en quantité suffisante pour couvrir ledit motif (20), ladite poudre métallique (30) adhérant audit adhésif dans ladite encre;
   - l'enlèvement de toutes quantités excessives de ladite poudre métallique (30) dudit motif (20); et
   - le chauffage dudit substrat (12) une température d'environ 100 à 250 degrés centigrade de façon à faire fondre ladite poudre métallique (30) sur ledit motif (20) afin de foimer sur lui un agencement de traces conductrices (50) identiques audit motif (20).

2. Procédé selon la revendication 1, dans lequel ledit substrat (12) comprend un matériau sélectionné parmi le polyester, le plastique acrylonitrile-butadiène-styrène, le plastique de chlorure de polyvinyle, le plastique de polycarbonate et des mélanges de ceux-ci.

7

3. Procédé selon l'une quelconque des revendications précédentes, dans lequel ladite poudre métallique (30) comprend un métal sélectionné parmi le plomb, l'étain, l'argent, l'indium, le bismuth, l'antimoine et des mélanges de ceux-ci.

4. Procédé selon l'une quelconque des revendications précédentes, dans lequel ladite poudre métallique (30) comprend une pluralité de particules individuelles ayant chacune un diamètre moyen d'environ 30 - 150 micromètres.

5. Procédé selon la revendication 7, dans lequel ledit substrat (12) portant ledit motif (20) et ladite poudre métallique (30) est chauffé auxdites températures pendant environ 0,5 - 10 minutes.

6. Procédé selon l'une quelconque des revendications précédentes dans lequel ledit enlèvement desdites quantités excessives de ladite poudre métallique (30) comprend l'agitation dudit substrat (12) portant ledit motif (20) et ladite poudre métallique (30) suffisamment pour déloger dudit substrat (12) lesdites quantités excessives de ladite poudre métallique (30).

FIG. 1

FIG. 2